# EUROPÄISCHE PATENTSCHRIFT

(11) **EP 2 206 157 B1**
(45) Veröffentlichungstag und Bekanntmachung des Hinweises auf die Patenterteilung: **24.01.2018**
(21) Anmeldenummer: 08846817.8
(22) Anmeldetag: 04.11.2008
(51) Int. Cl.: H01L 31/0392, H01L 31/042, H01L 27/142

(54) **SOLARZELLE**
SOLAR CELL
CELLULE SOLAIRE

(30) Priorität: 07.11.2007 DE 102007052928
(43) Veröffentlichungstag der Anmeldung: 14.07.2010
(73) Patentinhaber: Gottlieb Binder GmbH & Co. KG, 71084 Holzgerlingen (DE)
(72) Erfinder: TUMA, Jan, 71083 Herrenberg (DE)
(74) Vertreter: Crazzolara, Helmut
(86) Internationale Anmeldenummer: PCT/EP2008/009282
(87) Internationale Veröffentlichungsnummer: WO 2009/059738

(56) Entgegenhaltungen:
- DE-A1- 10 305 938
- DE-A1-102004 003 123

## Beschreibung

Die Erfindung betrifft eine Solarzelle mit einem flexiblen Substrat und mit mindestens einer auf dem Substrat aufgebrachten photovoltaischen Schicht zum Wandeln von Sonnenenergie in elektrische Energie.

Derartige Solarzellen werden üblicherweise in Dünnschichttechnologie hergestellt, beispielsweise monolithisch in einkristallinen Siliziumscheiben (wafer) integriert oder unter Verwendung von abgeschiedenen polykristallinen oder amorphen Siliziumschichten. Das photovoltaische Wirkprinzip beruht darauf, dass das eingestrahlte Sonnenlicht in der photovoltaischen Schicht Ladungsträger freisetzt, die getrennt zu jeweils einer Elektrode abgeführt werden, und dadurch an den Elektroden eine elektrische Spannung entsteht. Sowohl die Herstellung als auch die Montage der bekannten Solarzellen sind mit hohen Investitions- und Installationskosten verbunden, die einer großflächigen Anwendung von Solarzellen bisher entgegensteht.

Aus der DE 103 05 938 A1 ist eine flexible Dünnschichtsolarzelle bekannt, die durch Aufbringen von energiewandelnden Schichten auf ein flexibles Material und dessen Ausstattung mit einem universellen Haftmaterial wie einem Kleber hergestellt ist.

Aus der DE 196 46 318 A1 ist ein rationelles Verfahren zur Herstellung eines Haftverschlussteils aus thermoplastischem Kunststoff bekannt.

Aus der DE 10 2004 003 123 A1 ist ein Haftverschlussteil mit einem Leuchtmittel und ein Verfahren zum Herstellen eines solchen Haftverschlussteils bekannt.

Der Erfindung liegt die Aufgabe zugrunde, eine Solarzelle bereitzustellen, welche die Nachteile des Standes der Technik überwindet, insbesondere eine kostengünstige Erzeugung von Solarstrom durch eine kostengünstige Herstellung und Montage von Solarzellen ermöglicht. In einer Ausführungsart soll die Festlegung der Solarzelle an einer Trägereinrichtung vereinfacht sein und dadurch soll auch die Funktionalität und die Einsatzmöglichkeiten erfindungsgemäßer Solarzellen verbessert werden.

Die Aufgabe ist durch die im Anspruch 1 bestimmte Solarzelle gelöst. Besondere Ausführungsarten der Erfindung sind in den Unteransprüchen bestimmt.

In einer Ausführungsart weist die Solarzelle ein flexibles und daher biegsames und vorzugsweise auch elastisch verformbares Substrat auf, auf dem mindestens eine photovoltaische Schicht zum Wandeln von Sonnenenergie in elektrische Energie aufgebracht ist. Es können auch mehrere photovoltaische Schichten aufgebracht sein. Grundsätzlich kann das flexible Substrat auf beliebige Art und Weise hergestellt sein, beispielsweise kann es sich dabei auch um ein durch Stricken, Wirken oder Weben hergestelltes Substrat handeln, wie es beispielsweise in der Textilindustrie eingesetzt wird. In einer Ausführungsart ist das Substrat durch einen flächigen Polymerkunststoff gebildet, beispielsweise durch eine Polymerkunststofffolie. Es ist auch möglich, einen Sandwichaufbau zu verwenden, aufweisend beispielsweise einen durch Stricken, Weben oder Wirken hergestellten Bestandteil mit einer mindestens einseitigen und vorzugsweise ganzflächigen Beschichtung mit einem Polymerkunststoff.

Auf das Substrat kann beispielsweise durch übliche Herstellverfahren der Dünnschichttechnik oder Dickschichttechnik die eine photovoltaische Schicht oder mehrere photovoltaische Schichten aufgebracht werden. Besonders vorteilhaft ist dabei die Verwendung von organischen, insbesondere polymeren photovoltaischen Schichten, da diese über eine besonders hohe Flexibilität verfügen und dadurch die gesamte Solarzelle eine hohe Flexibilität aufweist. Als photovoltaische Absorberschichten können beispielsweise Halbleiterpolymere wie etwa Poly-3-alkylthiophene, konjugierte Low-Bandgap-Polymere oder Polyphenylenvinylene als p-leitendes Material und als n-Leiter beispielsweise C60-Fullerenderivate eingesetzt werden.

Neben den photovoltaischen Schichten weist die Solarzelle noch Elektroden auf, mit denen die Solarzelle elektrisch kontaktiert werden kann und an denen die Fotospannung ansteht. Vorzugsweise ist mindestens eine der Elektroden aus einem Werkstoff hergestellt, der für den Wellenlängenbereich der zu absorbierenden Strahlung transparent oder jedenfalls teilweise transparent ist. Auch das Substrat kann transparent oder teilweise transparent sein, so dass die zu absorbierende Strahlung auch über die Substratseite eingestrahlt werden kann. Alternativ hierzu kann auch ein opakes oder reflektives Substrat eingesetzt werden, oder es können opake oder reflektive Schichten auf das Substrat aufgebracht werden.

In einer Ausführungsart ist zwischen mindestens einer der Elektroden und der benachbarten photovoltaischen Absorberschicht eine polymere Zwischenschicht angeordnet, die durch Aufschleudern oder Spincoating auf die Elektrode aufgebracht sein kann, und auf dotiertem Polyethylendioxythiophen basieren kann und eine Dicke von 50 bis 200 nm, insbesondere 80 bis 100 nm aufweisen kann. Die polymere Zwischenschicht wirkt als Glättungsschicht und trägt zur Verbesserung der Ladungsträgerinjektion in die Elektrode bei.

In einer Ausführungsart können die Elektroden verteilt auf dem Substrat angeordnet sein, insbesondere kann das Substrat miteinander elektrisch verbundene Elektrodenflächen an verschiedenen Positionen aufweisen, insbesondere in einem regelmäßigen Muster angeordnete Elektrodenflächen, so dass die Solarzelle nicht nur an einer vorgegebenen Stelle, sondern an unterschiedlichen Positionen elektrisch kontaktierbar ist. Dies ist insbesondere bei großflächigen Solarzellen vorteilhaft, bei denen die Möglichkeit einer unterschiedlichen Zuführung der Anschlussleitungen oder der Kontakt mit mehreren Anschlussleitungen vorteilhaft ist.

In einer Ausführungsart ist mindestens ein Teil der auf das Substrat aufgebrachten Schichten durch Bedrucken, insbesondere durch Siebdruck oder Offsetdruck, durch Abscheiden aus der Gasphase oder Flüssigphase, durch Bedampfen oder Besprühen aufgebracht. Die Schichten können unstrukturiert aufgebracht sein und, soweit erforderlich, kann durch eine anschließende Strukturierung, beispielsweise unter Verwendung photolitografischer Schritte, eine Strukturierung der aufgebrachten Schicht erfolgen. Insbesondere im Falle des Siebdrucks können die Schichten auch bereits strukturiert aufgebracht werden.

In einer Ausführungsart ist mindestens ein Teil der Schichten durch die Tintenstrahldrucktechnik aufgebracht, bei der die aufzubringende Schicht unmittelbar oder gelöst in einem Trägerwerkstoff mittels einer Spritzdüse mit hoher Auflösung auf das Substrat aufgedruckt wird. Hierzu stehen eine große Auswahl von funktionellen organischen und anorganischen Tinten zur Verfügung, einschließlich Dispersionen oder Suspensionen mit festen Objekten, die über feine Düsen mit Durchmessern von wenigen Hundert Nanometern die Schichten auf dem Substrat erzeugen können. Auf diese Weise können auch elektronische Bauelemente oder elektronische Schaltungen auf das Substrat aufgebracht werden, durch welche die Solarzelle mit einer elektrischen Schaltung kombinierbar ist, oder die elektrische Schaltung mit der Solarzelle integriert herstellbar ist.

Das Substrat weist Integral Haftverschlusselemente auf, mittels denen das Substrat und mithin die Solarzelle werkzeuglos an einer Trägereinrichtung festlegbar ist. Die Haftverschlusselemente bilden dabei mit dem Substrat eine Baueinheit. Die Festlegekräfte können dabei durch mechanisches Verhaken und/oder durch chemische Bindungskräfte bereitgestellt werden.

Durch ein formgebendes Verfahren wie es beispielsweise in der DE 196 46 318 A1 beschrieben ist, sind Haftverschlusselemente herstellbar, insbesondere einstückig mit dem flächigen Substrat, die ein mechanisches Verhaken mit der Trägereinrichtung ermöglichen.
Die Haftverschlusselemente können dabei hakenförmig, pilzkopfförmig, schlaufenförmig oder sonstige geeignete Verhakungsformen aufweisen und können mit korrespondierenden Haftverschlusselementen der Trägereinrichtung zusammenwirken. Die Haftverschlusselemente des flächigen Substrats und der Trägereinrichtung können dabei identisch oder komplementär zueinander ausgebildet sein, beispielsweise sind Verbindungen von Haken-Haken, Pilzkopf-Pilzkopf, Haken-Schlaufen, Pilzkopf-Schlaufen oder dergleichen möglich.

Alternativ oder ergänzend können die Haftverschlusselemente des Substrats mit einer Oberfläche der Trägereinrichtung auch durch chemische Bindungskräfte zusammenwirken, insbesondere durch Adhäsionskräfte wie beispielsweise Van der Waalssche Kräfte oder Dipolkräfte zusammenwirken. Hierzu können beispielsweise einstückig mit dem flächigen Substrat ausgebildete Stängel an ihrem freien Ende in eine Vielzahl von Einzelfasern aufgeteilt sein, beispielsweise in mehrere Hundert Fasern je Stängel.

Die Haftverschlusselemente können auch so ausgebildet sein, dass die Enden der Stängel auf ihrer zur Oberfläche der Trägereinrichtung gerichteten Fläche eine Wölbung aufweisen, vorzugsweise eine konvexe Wölbung aufweisen, und vorzugsweise die zur Oberfläche der Trägereinrichtung gerichtete Fläche gegenüber dem sich anschließenden Bereich der Stängel verbreitert ist. Durch eine sich dadurch ergebende Einengung der Enden der Stängel ist eine Art Sollknickstelle definiert, die ein Ausrichten der zur Oberfläche der Trägereinrichtung gerichteten Fläche der Haftverschlusselemente auf die Oberfläche der Trägereinrichtung und damit eine großflächige Anlage der Haftverschlusselemente an die Oberfläche der Trägereinrichtung ermöglicht und/oder ein Ablösen der Haftverschlusselemente von der Trägereinrichtung mit geringeren Kräften ermöglicht. Die Stirnflächen der Stängel wirken mit der Oberfläche der Trägereinrichtung durch Adhäsionskräfte zusammen und dadurch ist das Substrat an der Trägereinrichtung festlegbar. Geeignete Kunststoffmaterialien für solche Haftverschlusselemente sind anorganische und organische Elastomere, insbesondere Polyvinylsiloxan, sowie additionsvernetzende Silikon-Elastomere, auch in der Form von ZweiKomponenten-Systemen sowie Acrylate. Auch der Einsatz von Kautschukmaterialien ist möglich.

In einer besonderen Ausführungsart der Erfindung sind die Haftverschlusselemente jedenfalls teilweise formwerkzeugfrei hergestellt. Ein zugehöriges Verfahren ist in DE 100 65 819 C1 und DE 101 06 705 C1 beschrieben. Hierbei wird ein Kunststoffmaterial mittels mindestens einer Auftragvorrichtung in aufeinanderfolgend abgegebenen Tröpfchen abgelagert, wobei die Orte der Ablagerung der Tröpfchen im Hinblick auf die Form der jeweils auszubildenden Haftverschlusselemente dreidimensional gewählt werden kann. Auf diese Weise lassen sich mit großer Formfreiheit beispielsweise in der Art eines Tintenstrahl-Druckverfahrens Hakenelemente, Pilzkopfelemente, Schlaufenelemente und dergleichen herstellen.

Das Befestigen der erfindungsgemäßen Solarzelle an der Trägereinrichtung und vorzugsweise auch das Ablösen von der Trägereinrichtung ist einfach und ohne Werkzeug möglich. Die Befestigungsmittel sind in der Art eines Klettverschlusses einfach, großflächig und/oder in sehr großer Anzahl und dadurch kostengünstig herstellbar und ermöglichen eine dauerhaft sichere Befestigung auch großflächiger Solarzellen.

In einer Ausführungsart ist das flächige Substrat aus einem Kunststoff hergestellt, insbesondere aus einem thermoplastischen Kunststoff. Alternativ hierzu kann das erste flächige Substrat auch aus einem duroplastischen Kunststoff hergestellt sein, insbesondere im Fall von formwerkzeugfrei hergestellten Haftverschlusselementen. Die Haftverschlusselemente bestehen vorzugsweise aus dem gleichen Werkstoff wie das erste flächige Substrat. Grundsätzlich kommen insbesondere Polyethylene und Polypropylene in Betracht. Darüber hinaus kann ein Kunststoffmaterial gewählt werden, das ausgewählt ist aus der Gruppe der Acrylate wie Polymethacrylate, Polyethylen, Polypropylene, Polyoxymethylene, Polyvinyliden-fluorid, Polymethylpenten, Polyethylenchlorotrifluoroethylen, Polyvinylfluorid, Polyethylenoxid, Polyethylenterephthalate, Polybutylenterephthalate, Nylon 6, Nylon 66 und Polybuten. Alternativ hierzu ist das Substrat aus einem anorganischen und organischen Elastomer hergestellt, insbesondere aus Polyvinylsiloxan, oder aus einem additionsvernetzenden Silikon-Elastomer.

In einer Ausführungsart sind die Haftverschlusselemente auf einer der photovoltaischen Schicht gegenüberliegenden Seite des Substrats angeordnet. Insbesondere im Fall eines für das einfallende Licht transparenten oder teilweise transparenten Substrats können die Haftverschlusselemente auch auf beiden Seiten des Substrats angeordnet sein, oder es können zwei Substrate, die jeweils Haftverschlusselemente aufweisen, miteinander verbunden sein, wobei die Haftverschlusselemente auf beiden Außenseiten des Substratverbundes abstehen können und zwischen den beiden Substraten die photovoltaische Schicht angeordnet sein kann.

In einer Ausführungsart sind erfindungsgemäße Solarzellen nicht nur werkzeuglos an nahezu beliebig geformte Trägereinrichtungen festlegbar, beispielsweise auf Kraftfahrzeugkarossen, Gebäudefassaden oder Gartenmöbel, sondern sowohl die Anbringung als auch das Ablösen der Solarzelle von der Trägereinrichtung kann werkzeuglos erfolgen. Durch den Verzicht auf ein separates Verbindungsmittel, insbesondere auf einen Klebstoff oder sonstige Befestigungsmittel, ist das Anbringen einfach und insbesondere ohne Eingriff in die Trägereinrichtung möglich. Sofern die Haftung auf Adhäsivkräften beruht, ist vor allem das Festlegen an glatten Oberflächen, wie beispielsweise Glasscheiben, besonders einfach und zuverlässig möglich.

In einer Ausführungsart sind erfindungsgemäße Solarzellen in einem besonders kostengünstigen Rolle-zu-Rolle-Herstellverfahren produzierbar. Dadurch können Solarzellen mit großen Flächen und gleichzeitig geringen Kosten hergestellt werden und bei geeigneter Anordnung der Anschlusselekktroden, insbesondere bei verteilt auf dem Substrat angeordneten und miteinander elektrisch verbundenen Anschlusselektroden, kann die Solarzelle nach dem Aufbringen auf der Trägereinrichtung passend zugeschnitten werden.

In einer Ausführungsart sind die Haftverschlusselemente nicht nur integral mit dem Substrat verbunden, beispielsweise indem eine Folie mit entsprechenden Haftverschlusselementen mit dem flexiblen Substrat der Solarzelle laminiert ist, sondern die Haftverschlusselemente sind sogar einstückig mit dem die photovoltaische Schicht tragenden Substrat ausgebildet. In diesem Fall kann die Solarzelle auf einem folienartigen und Haftverschlusselemente aufweisenden flexiblen Substrat durch Abscheiden der Elektroden und photovoltaischen Schichten aufgebaut werden, insbesondere im Rahmen eines Rolle-zu-Rolle-Herstellverfahrens. Dadurch lassen sich die Herstellkosten weiter reduzieren.

In einer Ausführungsart weist das Substrat auf mindestens einer Festlegefläche, vorzugsweise ganzflächig, eine Vielzahl von Haftverschlusselementen mit einer Dichte von mehr als 100 Haftverschlusselementen je cm² auf. Dies entspricht bei regelmäßiger Anordnung der Haftverschlusselemente einem Rastermaß von weniger als 1 mm. Vorzugsweise weist das Substrat eine Dichte von mehr als 2.500 Haftverschlusselementen je cm² auf. Dies entspricht bei regelmäßiger Anordnung der Haftverschlusselemente einem Rastermaß von weniger als 0,2 mm. Weiter vorzugsweise weist das Substrat eine Dichte von mehr als 10.000 Haftverschlusselementen je cm² auf, was einem Rastermaß von weniger 0,1 mm entspricht. Insbesondere weist die Solarzelle mehr als 40.000 Haftverschlusselemente je cm² auf, entsprechend einem Rastermaß von weniger als 50 *µ*m. In einer besonderen Ausführungsart weist die Solarzelle mehr als 250.000 Haftverschlusselemente je cm² auf, entsprechend einem Rastermaß von weniger als 20 *µ*m. Durch die hohe Anzahl von Haftverschlusselementen lässt sich sowohl das Anbringen als auch das Ablösen vereinfachen und gleichzeitig eine hohe Haftkraft erzeugen.

In einer Ausführungsart weist mindestens ein Teil der Haftverschlusselemente einen vom Substrat beabstandeten Festlegeabschnitt auf, der aufgrund der auf die Solarzelle wirkenden Gewichtskraft und/oder aufgrund einer manuell aufzubringenden Anpresskraft derart in flächige Anlage an die Trägereinrichtung bringbar ist, dass die auftretenten Adhäsionskräfte ausreichen, um die Solarzelle an der Trägereinrichtung festzulegen. Der Festlegeabschnitt ist vorzugsweise weichelastisch biegsam, so dass sich auch bei Anwendung geringer Kräfte eine großflächige Anlage an die Trägereinrichtung und damit eine hohe Festlegekraft allein durch Adhäsionskräfte erreichbar ist.

In einer Ausführungsart ist der Elastizitätsmodul der Anlageflächen der Haftverschlusselemente gegenüber dem angrenzenden Abschnitt des Haftverschlusselementes herabgesetzt. Hierzu kann das Haftverschlusselement an seinem der Trägereinrichtung zugewandten Ende eine Beschichtung mit einem geeigneten Werkstoff aufweisen. Die Beschichtung kann beispielsweise auf die Haftverschlusselemente aufgedruckt sein, oder bereits bei der Herstellung der Haftverschlusselemente aufgebracht werden, beispielsweise in eine hierfür verwendete Formwalze eingebracht sein, oder die hergestellten Haftverschlusselemente können in ein Bad aus einem geeigneten Werkstoff eingetaucht werden.

In einer Ausführungsart ist mindestens ein Teil der Haftverschlusselemente elektrisch leitfähig. Dadurch ist eine elektrische Kontaktierung der photovoltaischen Schicht möglich. Die Haftverschlusselemente dienen dabei als Anschlusselektroden und können beispielsweise durch Adhäsion an einer Metallelektrode, beispielsweise einer mit Gold beschichteten Elektrode, in elektrischen Kontakt mit dieser gebracht werden.

In einer Ausführungsart weist mindestens ein Teil der Haftverschlusselemente mindestens abschnittsweise an ihrer Oberfläche eine Beschichtung mit einem elektrisch leitfähigen Werkstoff auf. Diese Beschichtung kann beispielsweise durch Aufdrucken oder Eintauchen aufgebracht werden.

In einer Ausführungsart ist das Substrat auf seiner die Haftverschlusselemente aufweisenden Seite beschichtet, insbesondere mit einem elektrisch leitfähigen oder halbleitenden Werkstoff beschichtet, beispielsweise bedruckt. Die Beschichtung kann ganzflächig erfolgen und bei Bedarf anschließend strukturiert werden, oder die Beschichtung kann bereits strukturiert erfolgen, beispielsweise durch Bedrucken nach dem Siebdruckverfahren oder mit der Tintenstrahltechnik. Durch die Beschichtung auf der die Haftverschlusselemente aufweisenden Seite ergibt sich eine zusätzliche Verdrahtungsebene. So können beispielsweise Verbindungsleitungen auf der Rückseite des Substrats aufgebracht werden. In Verbindung mit einem abschnittsweise elektrisch leitfähigen Substrat, beispielsweise durch lokale Veränderungen des Polymerwerkstoffes des Substrates oder durch lokales Einbringen elektrisch leitfähiger Partikel, können auf diese Weise auch Durchkontaktierungen von der Rückseite des Substrates mit den Haftverschlusselementen auf die Vorderseite des Substrates mit der photovoltaischen Schicht bereitgestellt werden. Dadurch ist eine Rückseitenkontaktierung der Solarzelle möglich.

Weitere Vorteile, Merkmale und Einzelheiten der Erfindung ergeben sich aus den Unteransprüchen und der nachfolgenden Beschreibung, in der unter Bezugnahme auf die Zeichnungen mehrere Ausführungsbeispiele im Einzelnen beschrieben sind. Dabei können die in den Ansprüchen und in der Beschreibung erwähnten Merkmale jeweils einzeln für sich oder in beliebiger Kombination erfindungswesentlich sein. Zum Zweck der verständlicheren Darstellung sind die Zeichnungen nicht maßstabsgetreu.
- Fig. 1: zeigt einen Querschnitt durch ein erstes Ausführungsbeispiel einer erfindungsgemäßen Solarzelle,
- Fig. 2: zeigt einen Querschnitt durch eine alternative Ausführungsform eines Haftverschlusselements,
- Fig. 3: zeigt die Festlegung einer erfindungsgemäßen Solarzelle an einer Trägereinrichtung mittels Haftverschlusselementen,
- Fig. 4: zeigt einen Querschnitt durch ein zweites Ausführungsbeispiel einer erfindungsgemäßen Solarzelle, und
- Fig. 5: zeigt einen Querschnitt durch ein drittes Ausführungsbeispiel einer erfindungsgemäßen Solarzelle.

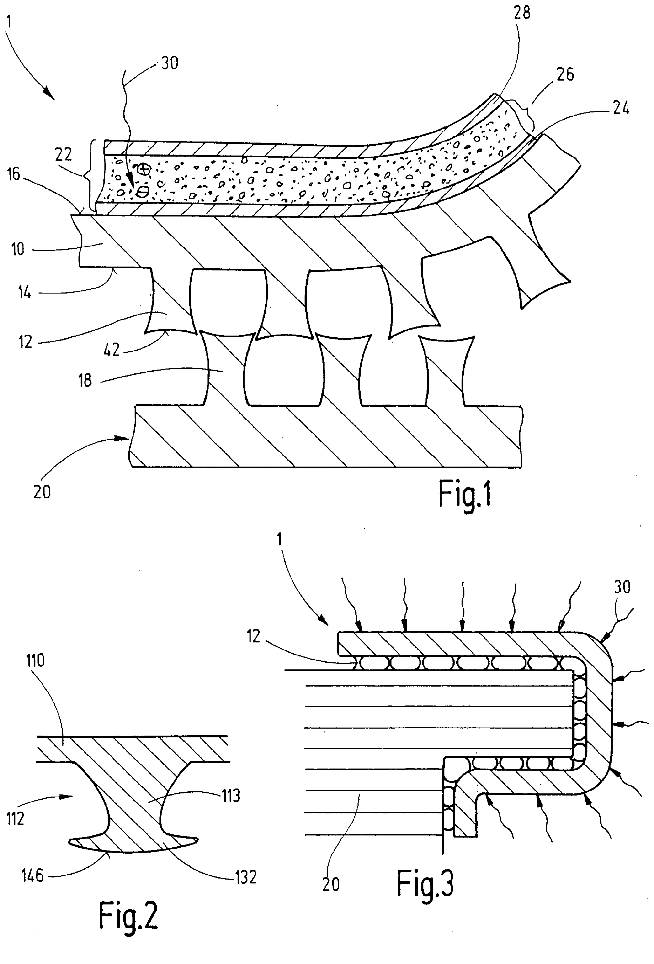

Die Fig. 1 zeigt einen Querschnitt durch ein erstes Ausführungsbeispiel einer erfindungsgemäßen Solarzelle 1. Die Solarzelle 1 weist ein flexibles Substrat 10 auf mit einer Vielzahl von in Reihen und Spalten regelmäßig angeordneten Haftverschlusselementen 12. Die Haftverschlusselemente 12 und das Substrat 10 sind einstückig ausgebildet. Das Substrat 10 ist aus einem Polymerkunststoff hergestellt, beispielsweise einem Thermoplast wie Polyamid oder Polypropylen, oder aus einem Duroplast wie Polyvinylsiloxan. Die Haftverschlusselemente 12 stehen von der ersten Oberfläche 14 schräg und vorzugsweise im rechten Winkel ab. Die Haftverschlusselemente 12 können im Wesentlichen zylindrisch sein oder die Form eines Hyperboloids aufweisen. Sie können insbesondere achsensymmetrisch zu einer im Zentrum der Haftverschlusselemente 12 verlaufenden und mit der ersten Oberfläche 14 einen rechten Winkel einschließenden Achse sein. An ihrem von der ersten Oberfläche 14 beabstandeten Ende weisen die Haftverschlusselemente eine konkav gewölbte Oberfläche 42 auf.

Die Solarzelle 1 kann mit einer Trägereinrichtung 20 zusammengefügt werden, die im Wesentlichen identisch wie das Substrat 10 aufgebaut ist, insbesondere können die Haftverschlusselemente 12 mit den identisch aufgebauten weiteren Haftverschlusselementen 18 lösbar in Eingriff gebracht werden, so dass die Solarzelle 10 an der Trägereinrichtung 20 lösbar festlegbar ist. Alternativ zu der Festlegung der Solarzelle 1 mittels der sich verhakenden Haftverschlusselemente 12, 18 können die Haftverschlusselemente 12 des Substrats 10 auch mit einem textilen Haftverschlusselement, beispielsweise einem Flausch- oder Schlaufenmaterial, oder unmittelbar mit einem textilen Bekleidungsstück oder einer Trägereinrichtung mit einer textilen Oberfläche zusammengefügt werden.

An einer der ersten Oberfläche 14 gegenüberliegenden zweiten Oberfläche 16 ist auf das Substrat 10 eine Schichtfolge 22 aufgebracht, die angrenzend an das Substrat 10 oder angrenzend an eine auf dem Substrat 10 angebrachte Zwischenschicht eine erste Elektrode 24, die photovoltaische Schicht 26 und eine zweite Elektrode 28 umfasst. In der photovoltaischen Schicht 26 wird einfallendes Licht 30 absorbiert und dabei entstehen Ladungsträger, insbesondere Elektronen-Loch-Paare. Die so entstandenen Ladungsträger werden getrennt und an die beiden an die photovoltaische Schicht 26 angrenzenden Elektroden 24, 28 transportiert, so dass an diesen Elektroden 24, 28 eine elektrische Spannung entsteht.

In der Fig. 1 ist der Einfall von Licht 30 über die zweite Elektrode 28 dargestellt; hierzu muss die zweite Elektrode 28 aus einem Werkstoff bestehen, der für den Wellenlängenbereich des einfallenden Lichts 30 transparent oder jedenfalls teilweise transparent ist. Geeignet sind hierfür elektrisch leitende oder jedenfalls halbleitende Oxyde wie beispielsweise Indium-Zinn-Oxyd. Die Dicke der Elektrode kann zwischen 50 und 500 nm betragen, vorzugsweise zwischen 100 und 300 nm und insbesondere zwischen 150 und 250 nm. In einer Ausführungsart ist auch der Werkstoff des Substrats 10 transparent oder jedenfalls teilweise transparent für das einfallende Licht 30. In diesem Fall kann die Lichteinstrahlung alternativ oder ergänzend auch über das Substrat 10 erfolgen. Die Elektroden 24, 28 können ganzflächig oder strukturiert sein. Sofern eine der Elektroden 24, 28 nicht transparent sein muss, kann als Werkstoff ein Metall eingesetzt werden, beispielsweise Aluminium.

In einer Ausführungsart ist die photovoltaische Schicht 26 ihrerseits ein Mehrschichtsystem und kann insbesondere zwei Schichten umfassen, etwa ein p-leitendes Halbleiterpolymer, beispielsweise Poly-3-alkylthiophe, konjugierte Low-Bandgap-Polymere oder Polyphenylenvinylene, und einen organischen Akzeptor als n-Leiter, beispielsweise C60-Fullerenderivate.

Die Elektroden 24, 28 und/oder die photovoltaische Schicht 26 können strukturiert oder unstrukturiert auf das Substrat 10 aufgebracht sein, beispielsweise durch Aufschleudern einer Flüssigphase oder Spincoating. Alternativ hierzu kann mindestens ein Teil der Schichten auch mittels einer Tintenstrahldruckertechnologie aufgebracht sein, durch die hoch auflösende Elektrodengeometrien realisiert werden können oder die Zusammensetzung der photovoltaischen Schicht 26 über die Schichtdicke variiert werden kann.

Alternativ zu dem ersten Ausführungsbeispiel der Fig. 1 kann die Festlegung der Solarzelle 1 nicht oder jedenfalls nicht nur durch ein Verhaken der Haftverschlusselemente 12 mit der Trägereinrichtung 20 erfolgen, sondern alternativ oder ergänzend durch Adhäsion der Haftverschlusselemente 12 an einer nahezu beliebig gestalteten Oberfläche der Trägereinrichtung 20. In diesem Fall ist es vorteilhaft, wenn die der Trägereinrichtung 20 zugewandten Enden der Haftverschlusselemente 12 weichelastisch verformbar sind, damit die Enden der Haftverschlusselemente 12 mit geringer Anpresskraft, vorzugsweise allein aufgrund der auf die Solarzelle 10 wirkenden Gravitationskraft oder aufgrund einer manuell aufzubringenden Anpresskraft, in möglichst großflächige Anlage an die Trägereinrichtung 20 kommen. Hierzu können die Haftverschlusselemente 12 entweder an ihren Enden derart modifiziert werden, dass sie einen geringen Elastizitätsmodul aufweisen, beispielsweise durch Bestrahlung oder Exposition in einem Plasma, oder es kann eine Beschichtung auf die Enden der Haftverschlusselemente 12 aufgebracht werden. Die mittels Adhäsionskräften festlegbaren Solarzellen 1 weisen vorzugsweise ein Substrat 10 aus einem Duroplast auf, insbesondere aus einem duroplastischen Elastomer, beispielsweise aus Polyvinylsiloxan.

Die Fig. 2 zeigt einen Querschnitt durch eine alternative Ausführungsform eines Haftverschlusselements 112, das an seinem vom Substrat 110 weg weisenden und der Trägereinrichtung 20 zugewandten Endabschnitt 132 dahingehend modifiziert sein kann, dass es jedenfalls an der Oberfläche 146 einen gegenüber dem anschließenden Abschnitt des Haftverschlusselements 112 herabgesetzten Elastizitätsmodul aufweist. Der Oberflächenabschnitt 132 ist an seinem freien Ende konvex gewölbt, um beim Anlegen an die Trägereinrichtung 20 eine möglichst großflächige Kontaktierung der Trägereinrichtung 20 zu gewährleisten. Außerdem weist der Endabschnitt 132 eine größere radiale Erstreckung auf als der an den Endabschnitt 132 angrenzende Abschnitt eines Verbindungsabschnitts 113 des Haftverschlusselements 112. Durch die taillenartige Einschnürung am Übergang des Verbindungsabschnitts 113 zum Endabschnitt 132 des Haftverschlusselements 112 kann auch eine mit geringen Kräften auslenkbare Gelenkstelle gebildet sein, durch die eine großflächige Kontaktierung der Trägereinrichtung 20 gewährleistet ist.

In einem alternativen Ausführungsbeispiel kann die größere radiale Erstreckung des Endabschnitts 132 auch nur in eine Richtung erfolgen, dann allerdings vorzugsweise um einen Betrag von mindestens 20 % des Durchmessers des an den Endabschnitt 132 angrenzenden Abschnitt des Verbindungsabschnitts 113. Der Endabschnitt 132 kann entweder durch lokale Modifikation des Werkstoffes des Haftverschlusselements 112 gebildet sein, oder auf den Verbindungsabschnitt 113 kann endseitig ein geeigneter, den Endabschnitt 132 bildender Werkstoff aufgebracht sein, oder der Endabschnitt 132 kann beim Herstellen der Haftverschlusselemente 112 gebildet sein, beispielsweise durch Kalandrieren der Haftverschlusselemente 112, oder nach dem Herstellen durch Eintauchen der Haftverschlusselemente 112 in eine geeignete Lösung gebildet sein.

Die Fig. 3 zeigt die Festlegung einer erfindungsgemäßen Solarzelle 1 an einer Trägereinrichtung 20 mittels Haftverschlusselementen 12. Ohne zusätzlich erforderliche Verbindungsmittel oder Verbindungsschichten kann die Solarzelle 1 aufgrund der Flexibilität des Substrates 10 und der darauf aufgebrachten Schichtenfolge 22 entsprechend der Kontur der Oberfläche der Trägereinrichtung 20 großflächig angebracht werden, so dass das Licht 30 auch aus unterschiedlichen Richtungen, beispielsweise entsprechend einem wandernden Sonnenstand, von der Solarzelle 1 in elektrische Energie umgewandelt werden kann.

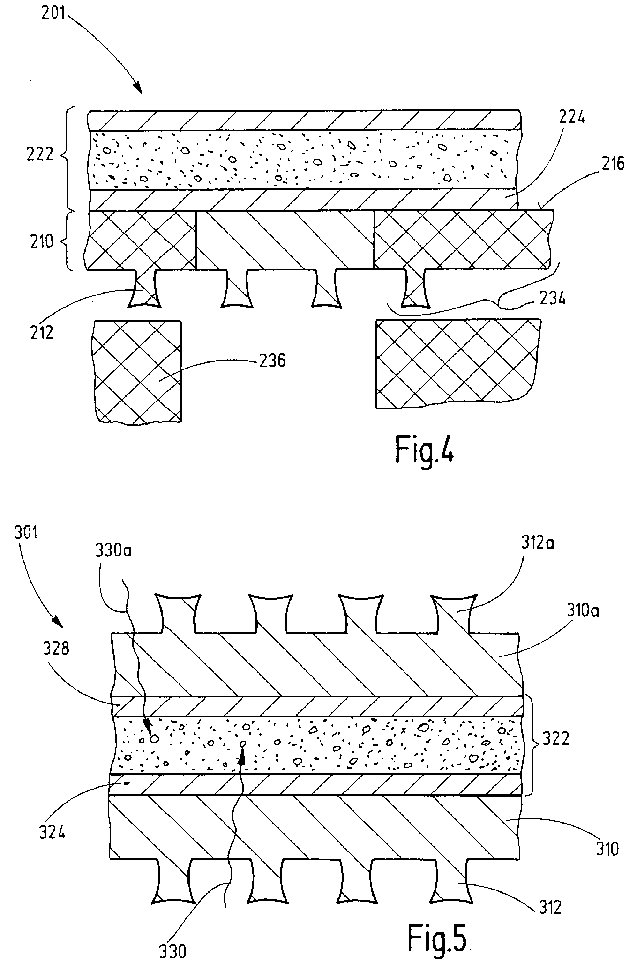

Die Fig. 4 zeigt einen Querschnitt durch ein zweites Ausführungsbeispiel einer erfindungsgemäßen Solarzelle 201. Das vorzugsweise aus einem thermoplastischen Kunststoff hergestellte Substrat 210 ist in mindestens einem Bereich 234 ebenso wie die in diesem Bereich 234 angeordneten Haftverschlusselemente 212 durch Modifikation des Kunststoffes elektrisch leitfähig gemacht, wie dies durch die Kreuzschraffur angedeutet ist, beispielsweise durch Einlagerung leitfähiger Partikel. In diesen Bereichen 234 kontaktiert das Substrat 210 die auf der zweiten Oberfläche 216 angeordnete Schichtfolge 222, insbesondere die erste Elektrode 224. Auf diese Weise kann die erste Elektrode 224 von der Rückseite der Solarzelle 201 elektrisch kontaktiert werden, beispielsweise über externe Kontaktelektroden 236.

Die Fig. 5 zeigt einen Querschnitt durch ein drittes Ausführungsbeispiel einer erfindungsgemäßen Solarzelle 301. Auf beiden Seiten der Schichtfolge 322 ist jeweils ein flexibles Substrat 310, 310a angeordnet, das wiederum jeweils auf seiner der Schichtfolge 322 abgewandten Seite einstückig Haftverschlusselemente 312, 312a aufweist. Eines oder beide Substrate 310, 310a sind für das einfallende Licht transparent oder teilweise transparent, so dass die Einstrahlung über das eine oder über beide Substrate 310, 310a erfolgen kann. Die Festlegung an einer Trägereinrichtung 20 kann wahlweise über das eine Substrat 310 oder das andere Substrat 310a erfolgen. Die elektrische Kontaktierung der Elektroden 324, 328 und mithin der Solarzelle 301 kann in einem substratfreien Abschnitt außerhalb des in der Fig. 5 dargestellten Abschnitts erfolgen oder über das jeweils zugeordnete Substrat 310, 310a entsprechend der Kontaktierung des zweiten Ausführungsbeispiels der Fig. 4.

## Patentansprüche

1. Solarzelle (1) mit einem flexiblem Substrat (10), vorzugsweise aus einem Polymerkunststoff, und mit mindestens einer auf dem Substrat (10) aufgebrachten photovoltaischen Schicht (26) zum Wandeln von Sonnenenergie in elektrische Energie, wobei die Solarzelle (1) Haftverschlusselemente (12) aufweist, mittels denen die Solarzelle (1) werkzeuglos an einer Trägereinrichtung (20) festlegbar ist, **dadurch gekennzeichnet, dass** die Haftverschlusselemente (12) einstückig mit dem Substrat (10) ausgebildet sind, auf welches die photovoltaische Schicht (26) in Dünn- oder Dickschichttechnik aufgebracht ist.

2. Solarzelle nach Anspruch 1, **dadurch gekennzeichnet, dass** die photovoltaische Schicht (26) eine organische, insbesondere eine polymere photovoltaische Schicht ist.

3. Solarzelle (1) nach Anspruch 1 oder einem der vorstehenden Ansprüche, **dadurch gekennzeichnet, dass** auf mindestens einer Festlegefläche, vorzugsweise ganzflächig, das Substrat (10) eine Vielzahl von Haftverschlusselementen (12) mit einer Dichte von mehr als 100 Haftverschlusselementen je cm² aufweist, insbesondere mehr als 2.500 Haftverschlusselementen je cm² aufweist.

4. Solarzelle (1) nach Anspruch 1 oder einem der vorstehenden Ansprüche, **dadurch gekennzeichnet, dass** auf mindestens einer Festlegefläche, vorzugsweise ganzflächig, das Substrat (10) eine Vielzahl von Haftverschlusselementen (12) mit einer Dichte von mehr als 10.000 Haftverschlusselementen je cm² aufweist, insbesondere mehr als 40.000 Haftverschlusselementen je cm² aufweist, und vorzugsweise mehr als 250.000 Haftverschlusselementen je cm² aufweist.

5. Solarzelle (1) nach Anspruch 1 oder einem der vorstehenden Ansprüche, **dadurch gekennzeichnet, dass** mindestens ein Teil der Haftverschlusselemente (12) von dem Substrat (10) beabstandet einen Festlegeabschnitt aufweist, der aufgrund der auf die Solarzelle (1) wirkenden Gravitationskraft und/oder aufgrund einer manuell aufzubringenden Anpresskraft derart in flächige Anlage an die Trägereinrichtung (20) bringbar ist, dass die auftretenden Adhäsionskräfte ausreichen, um die Solarzelle (1) an der Trägereinrichtung (20) festzulegen.

6. Solarzelle (1) nach Anspruch 1 oder einem der vorstehenden Ansprüche, **dadurch gekennzeichnet, dass** die Haftverschlusselemente (12) von dem Substrat (10) beabstandet eine Beschichtung aufweisen mit einem Werkstoff, dessen Elastizitätsmodul geringer ist als der Elastizitätsmodul des Haftverschlusselements (12).

7. Solarzelle (1) nach Anspruch 1 oder einem der vorstehenden Ansprüche, **dadurch gekennzeichnet, dass** mindestens ein Teil der Haftverschlusselmente (12) elektrisch leitfähig ist.

8. Solarzelle (1) nach Anspruch 1 oder einem der vorstehenden Ansprüche, **dadurch gekennzeichnet, dass** mindestens ein Teil der Haftverschlusselemente (12) mindestens abschnittsweise an ihrer Oberfläche eine Beschichtung mit einem elektrisch leitfähigen Werkstoff aufweisen.

9. Solarzelle (1) nach Anspruch 1 oder einem der vorstehenden Ansprüche, **dadurch gekennzeichnet, dass** das Substrat (10) auf seiner die Haftverschlusselemente (12) aufweisenden Seite bedruckt ist, insbesondere mit einem elektrisch leitfähigen oder halbleitenden Werkstoff bedruckt ist.

10. Solarzelle (1) nach Anspruch 1 oder einem der vorstehenden Ansprüche, **dadurch gekennzeichnet, dass** das Substrat (10) auf seiner die Haftverschlusselemente (12) aufweisenden Seite strukturiert bedruckt ist, vorzugsweise mit einem Tintenstrahldruckverfahren bedruckt ist, insbesondere mit einem elektrisch leitfähigen oder halbleitenden Werkstoff bedruckt ist.

## Claims

1. A solar cell (1) having a flexible substrate (10), preferably made of a polymer plastic, and having at least one photovoltaic layer (26) applied to the substrate (10) for converting solar energy into electrical energy, the solar cell (1) having adhesive fastener elements (12) by means of which the solar cell (1) can be affixed onto a carrier means (20) without tools, **characterised in that** the adhesive fastener elements (12) are made in one piece with the substrate (10) onto which the photovoltaic layer (26) is attached using thin or thick film technology.

2. The solar cell according to Claim 1, **characterised in that** the photovoltaic layer (26) is an organic, in particular a polymeric photovoltaic layer.

3. The solar cell (1) according to Claim 1 or either of the preceding claims, **characterised in that** on at least one affixing surface, preferably over the entire surface, the substrate (10) has a plurality of adhesive fastener elements (12) with a density of more than 100 adhesive fastener elements per cm², in particular more than 2,500 adhesive fastener elements per cm².

4. The solar cell (1) according to Claim 1 or any of the preceding claims, **characterised in that** on at least one affixing surface, preferably over the entire surface, the substrate (10) has a plurality of adhesive fastener elements (12) with a density of more than 10,000 adhesive fastener elements per cm², in particular more than 40,000 adhesive fastener elements per cm², and preferably more than 250,000 adhesive fastener elements per cm².

5. The solar cell (1) according to Claim 1 or any of the preceding claims, **characterised in that** at least some of the adhesive fastener elements (12) have an affixing section spaced apart from the substrate (10) which, as a result of the force of gravity acting on the solar cell (1) and/or as a result of a contact pressure which can be applied manually, can be brought into flat contact with the carrier means (20) such that the adhesion forces which occur are sufficient to affix the solar cell (1) to the carrier means (20).

6. The solar cell (1) according to Claim 1 or any of the preceding claims, **characterised in that** the adhesive fastener elements (12) have, spaced apart from the substrate (10), a coating with a material the modulus of elasticity of which is less than the modulus of elasticity of the adhesive fastener element (12).

7. The solar cell (1) according to Claim 1 or any of the preceding claims, **characterised in that** at least some of the adhesive fastener elements (12) are electrically conductive.

8. The solar cell (1) according to Claim 1 or any of the preceding claims, **characterised in that** at least some of the adhesive fastener elements (12) have a coating with an electrically conductive material at least in some sections on their surface.

9. The solar cell (1) according to Claim 1 or any of the preceding claims, **characterised in that** the substrate (10) is printed on its side that has the adhesive fastener elements (12), and in particular is printed with an electrically conductive or semiconducting material.

10. The solar cell (1) according to Claim 1 or any of the preceding claims, **characterised in that** the substrate (10) is printed in a structured manner on its side that has the adhesive fastener elements (12), and preferably is printed using an inkjet printing process, in particular is printed with an electrically conductive or semiconducting material.

## Revendications

1. Cellule (1) solaire, comprenant un substrat (10) souple, de préférence en une matière plastique polymère et au moins une couche (26) photovoltaïque déposée sur le substrat (10) pour transformer de l'énergie solaire en énergie électrique, la cellule (1) solaire ayant des éléments (12) de fermeture autoagrippante au moyen desquels la cellule (1) solaire peut être fixée sans outil à un dispositif (20) de support, **caractérisée en ce que** les éléments (12) de fermeture autoagrippante sont constitués d'une seule pièce avec le substrat (10), sur lequel la couche (26) photovoltaïque est déposée, suivant une technique en couche mince ou en couche épaisse.

2. Cellule solaire suivant la revendication 1, **caractérisée en ce que** la couche (26) photovoltaïque est une couche organique, notamment une couche photovoltaïque polymère.

3. Cellule (1) solaire suivant la revendication 1 ou l'une des revendications précédentes, **caractérisée en ce que**, sur au moins une surface de fixation, de préférence sur toute la surface, le substrat (10) a une pluralité d'éléments (12) de fermeture autoagrippante en une densité de plus de 100 éléments de fermeture autoagrippante par cm², notamment de plus de 2.500 éléments de fermeture autoagrippante par cm².

4. Cellule (1) solaire suivant la revendication 1 ou l'une des revendications précédentes, **caractérisée en ce que**, sur au moins une surface de fixation, de préférence sur toute la surface, le substrat (10) a une pluralité d'éléments (12) de fermeture autoagrippante en une densité de plus de 10.000 éléments de fermeture autoagrippante par cm², notamment de plus de 40.000 éléments de fermeture autoagrippante par cm² et de préférence de plus de 250.000 éléments de fermeture autoagrippante par cm².

5. Cellule (1) solaire suivant la revendication 1 ou l'une des revendications précédentes, **caractérisée en ce qu'**au moins une partie des éléments (12) de fermeture autoagrippante a, à distance du substrat (10), un segment de fixation qui, en raison de la force de gravité agissant sur la cellule (1) solaire et/ou en raison d'une force d'application d'une pression manuelle, peut être mis en contact de surface avec le dispositif (20) de support, de manière à ce que les forces d'adhérence, qui se produisent, suffisent à fixer la cellule (1) solaire au dispositif (10) de support.

6. Cellule (1) suivant la revendication 1 ou l'une des revendications précédentes, **caractérisée en ce que** les éléments (12) de fermeture autoagrippante ont, à distance du substrat (10) un revêtement comprenant un matériau, dont le module d'élasticité est plus petit que le module d'élasticité de l'élément (12) de fermeture autoagrippante.

7. Cellule (1) suivant la revendication 1 ou l'une des revendications précédentes, **caractérisée en ce qu'**au moins une partie des éléments (12) de fermeture autoagrippante est conductrice de l'électricité.

8. Cellule (1) suivant la revendication 1 ou l'une des revendications précédentes, **caractérisée en ce qu'**au moins une partie des éléments (12) de fermeture autoagrippante ont, au moins par endroit sur leur surface, un revêtement en un matériau conducteur de l'électricité.

9. Cellule (1) suivant la revendication 1 ou l'une des revendications précédentes, **caractérisée en ce que** le substrat (10) est imprimé sur sa face ayant les éléments (12) de fermeture autoagrippante, en étant imprimé notamment d'un matériau conducteur de l'électricité ou semi-conducteur.

10. Cellule (1) suivant la revendication 1 ou l'une des revendications précédentes, **caractérisée en ce que** le substrat (10) est imprimé de façon structurée sur sa face ayant les éléments (12) de fermeture autoagrippante, de préférence par un procédé d'impression à jet d'encre, en étant imprimé notamment d'un matériau conducteur de l'électricité ou semi-conducteur.
